# EUROPÄISCHE PATENTSCHRIFT

(11) **EP 3 365 922 B1**
(45) Veröffentlichungstag und Bekanntmachung des Hinweises auf die Patenterteilung: **13.01.2021**
(21) Anmeldenummer: 16774857.3
(22) Anmeldetag: 28.09.2016
(51) Int. Cl.: H01L 33/06, H01L 33/18

(54) **QUANTENPUNKT-BASIERTER LICHTEMITTER, INSBESONDERE ZUR EINZELPHOTONENEMISSION, UND VERFAHREN ZU DESSEN HERSTELLUNG**
QUANTUM-DOT-BASED LIGHT EMITTER, MORE PARTICULARLY FOR SINGLE PHOTON EMISSION, AND METHOD FOR PRODUCING SAME
ÉMETTEUR DE LUMIÈRE À POINT QUANTIQUE, EN PARTICULIER POUR L'ÉMISSION DE PHOTONS UNIQUES, ET SON PROCÉDÉ DE FABRICATION

(30) Priorität: 23.10.2015 DE 102015013765
(43) Veröffentlichungstag der Anmeldung: 29.08.2018
(73) Patentinhaber: Forschungsverbund Berlin E.V., 12489 Berlin (DE)
(72) Erfinder: BRANDT, Oliver, 10717 Berlin (DE); FERNÁNDEZ GARRIDO, Sergio, 28035 Madrid (ES); GEELHAAR, Lutz, 10825 Berlin (DE); MARQUARDT, Oliver, 12623 Berlin (DE); ZETTLER, Johannes, 12587 Berlin (DE)
(74) Vertreter: v. Bezold & Partner Patentanwälte - PartG mbB
(86) Internationale Anmeldenummer: PCT/EP2016/001614
(87) Internationale Veröffentlichungsnummer: WO 2017/067627

(56) Entgegenhaltungen:
- WO-A1-2014/138904
- US-A1- 2012 223 289
- MARK J. HOLMES ET AL: "Room-Temperature Triggered Single Photon Emission from a III-Nitride Site-Controlled Nanowire Quantum Dot", NANO LETTERS, Bd. 14, Nr. 2, 12. Februar 2014 (2014-02-12), Seiten 982-986, XP055317896, US ISSN: 1530-6984, DOI: 10.1021/nl404400d
- LANCE BROCKWAY ET AL: "A Postsynthesis Decomposition Strategy for Group III-Nitride Quantum Wires", CRYSTAL GROWTH & DESIGN., Bd. 11, Nr. 10, 5. Oktober 2011 (2011-10-05), Seiten 4559-4564, XP055317941, US ISSN: 1528-7483, DOI: 10.1021/cg200809k
- DESHPANDE SANIYA ET AL: "Blue single photon emission up to 200 K from an InGaN quantum dot in AlGaN nano", APPLIED PHYSICS LETTERS, A I P PUBLISHING LLC, US, vol. 102, no. 16, 22 April 2013 (2013-04-22), pages 161114-161114, XP012172610, ISSN: 0003-6951, DOI: 10.1063/1.4803441 [retrieved on 2013-04-25]

## Beschreibung

Die Erfindung betrifft eine Quantenpunkt-basierte, lichtemittierende Halbleitereinrichtung (Lichtemitter), insbesondere mit einem GaN- und/oder AlN-basierten Nanodraht, der mindestens einen InN-basierten Quantenpunkt aufweist. Des Weiteren betrifft die Erfindung Verfahren zur Herstellung der lichtemittierenden Halbleitereinrichtung. Anwendungen der Erfindung sind in der Optoelektronik, insbesondere bei der Herstellung von Einzelphotonenquellen, z. B. für Datenübertragungszwecke, und bei der Bereitstellung miniaturisierter Lichtquellen gegeben.

Zur Darstellung des Standes der Technik zur Herstellung, Charakterisierung und Anwendung von miniaturisierten, lichtemittierenden Halbleitereinrichtungen, insbesondere Nanodrähten und Quantenpunkten, wird auf die folgenden Publikationen Bezug genommen:
[1] K. Takemoto et al. in "Jpn. J. Appl. Physics, Part 2", 2004, Bd. 43, S. L349-L351;
[2] M. J. Holmes et al. in "Nano Lett.", 2014, Bd. 14, S. 982-986;
[3] Y. F. Ng et al. in "Appl. Phys. Lett.", 2002, Bd. 81, S. 3960-3962;
[4] B. Daudin in "Turk. J. Phys.", 2014, Bd. 38, S. 314-322;
[5] S. Deshpande et al. in "Appl. Phys. Lett.", 2013, Bd. 102, S. 161114;
[6] S. Deshpande et al. in "Appl. Phys. Lett.", 2013, Bd. 103, S. 241117;
[7] DE 10 2011 118 273 A1;
[8] L. Brockway et al. in "Cryst. Growth Des.", 2011, Bd. 11, S. 4559-4564;
[9] E. Ertekin et al. in "J. Appl. Phys.", 2005, Bd. 97, S. 114325;
[10] H. Geng et al. in "J. Appl. Phys.", 2012, Bd. 112, S. 114307;
[11] V. M. Kaganer et al. in "Phys. Rev. B", 2012, Bd. 85, S. 125402;
[12] F. Glas in "Phys. Rev. B", 2006, Bd. 74, S. 121302;
[13] Y. N. Guo et al. in "Appl. Phys. Lett.", 2006, Bd. 89, S. 87-90;
[14] Y. H. Kim et al. in "Appl. Phys. Lett", 2009, Bd. 95, S. 033112;
[15] L. Geelhaar et al. in "Sel. Top. Quantum Electron. IEEE J.", 2011, Bd. 17, S. 878-888;
[16] M. D. Brubaker et al. in "Nano Lett.", 2013, Bd. 13, S.-374-377;
[17] WO 2014/138904 A1; und
[18] US 2012/223289 A1.

Halbleiter-basierte Lichtemitter haben zahlreiche Anwendungen z. B. in der Beleuchtungstechnik, Sensorik, Messtechnik, Optoelektronik und Datenübertragungstechnik. Es ist allgemein bekannt, dass die Emissionseigenschaften der Lichtemitter, wie z. B. die Wellenlänge und/oder die Intensität des emittierten Lichts, durch eine geeignete Wahl des Halbleitermaterials, der Geometrie des Lichtemitters und seiner Betriebsweise eingestellt werden können. Beispielsweise kann die Emissionswellenlänge durch die Einstellung der Zusammensetzung eines Mischhalbleiters festgelegt werden.

Mischhalbleiter, insbesondere mit drei (ternäre Halbleiter) oder mehr Komponenten, können Fluktuationen der Zusammensetzung aufweisen, was sich nachteilig auf die Einstellung der Emissionseigenschaften auswirken kann. Es besteht daher ein Interesse an Lichtemittern, die auf binären Halbleitern basieren. Diese haben jedoch den Nachteil, dass die Zusammensetzung durch die Stöchiometrie des Mischhalbleiters festgelegt ist, so dass die Emissionseigenschaften nicht durch eine Variation der Zusammensetzung beeinflusst werden können.

In jüngster Zeit ist ein besonderes Interesse an Halbleiterbasierten Lichtemittern entstanden, die für einen Betrieb als Einzelphotonenquellen ausgelegt sind. Eine Einzelphotonenquelle zeichnet sich allgemein dadurch aus, dass in Reaktion auf ein Auslösesignal (oder: Triggersignal, Betriebssignal, Steuersignal), z. B. ein elektrisches oder ein optisches Auslösesignal, von dem Lichtemitter genau ein Photon emittiert wird. Einzelphotonenquellen finden bei der optischen Datenübertragung, insbesondere bei Übertragungsverfahren mit Quantenschlüsselaustausch (quantum key distribution, QKD) Anwendung. QKD-Systeme sind zwar bereits vereinzelt verfügbar. Für eine routinemäßige, massenhafte Nutzung sind jedoch noch erhebliche Verbesserungen der Einzelphotonenquellen, insbesondere in Bezug auf die Kosten, die Größe und die Komplexität der Herstellung erforderlich.

Als Lichtemitter einer Einzelphotonenquelle kann beispielsweise ein Quantenpunkt ("quantum dot", QD) verwendet werden. Quantenpunkte, die auch als "künstliche Atome" bezeichnet werden, haben eine Größe, die mit der De-Broglie-Wellenlänge der Elektronen im Quantenpunkt vergleichbar ist. Quantenpunkte haben daher eine Bandstruktur mit einem Spektrum diskreter Energieniveaus, die für die Einzelphotonenemission bei einer bestimmten Wellenlänge erforderlich und durch eine gezielte Beeinflussung der Bandlücke im Quantenpunkt eingestellt werden können. Von Interesse sind insbesondere Wellenlängen, die an eines der drei Transmissionsfenster der bestehenden Datenübertragungstechnik bei 0,85 µm, 1,31 µm und 1,55 µm angepasst sind.

Für Wellenlängen insbesondere bei den genannten Transmissionsfenstern wurden bereits Quantenpunkt-basierte Einzelphotonenquellen beschrieben [1], deren Funktion jedoch auf niedrige Temperaturen beschränkt ist. Für praktische Anwendungen ist jedoch ein Betrieb bei Raumtemperatur von Interesse. Dies erfordert ein Halbleitermaterial mit einem derart starken Einschluss ("confinement"), dass ein Energieabstand des Grundzustands und der angeregten Zustände von Ladungsträgern erreicht wird, der größer als k_{B}T ist, und eine thermische Emission aus dem Quantenpunkt unterbunden wird. Herkömmliche Quantenpunkte mit Einzelphotonenemission bei Raumtemperatur erfordern daher Halbleitermaterial mit einer relativ großen Bandlücke [2], so dass sich jedoch eine kurzwellige Emission mit Wellenlängen weit unterhalb der genannten Transmissionsfenster ergibt. Ein Halbleiter-basierter Lichtemitter mit einem Quantenpunkt zur Einzelphotonenemission für einen Betrieb bei Raumtemperatur und bei einer Wellenlänge im infraroten Spektralbereich, insbesondere bei einem der genannten Transmissionsfenster, ist bisher nicht verfügbar. Die bisher vorgeschlagenen Materialsysteme für Quantenpunkte schließen prinzipiell eine Erfüllung beider Anforderungen (Betrieb bei Raumtemperatur, langwellige Emission) aus.

Die binären Mischhalbleiter GaN und InN sind aufgrund ihrer Bandlücken-Energien von 3,4 eV und 0,6 eV geeignete Kandidaten für die Herstellung von Quantenpunkten mit einem starken Einschluss und einer Emission im gewünschten Wellenlängenbereich. Von Nachteil ist jedoch, dass GaN und InN einen relativ großen Unterschied der Gitterkonstanten (10%) aufweisen, so dass bisher die Herstellung von versetzungsfreien InN/GaN-Quantenpunkten mit herkömmlichen Epitaxieverfahren zur Herstellung planarer Schichtstrukturen ausgeschlossen war [3].

Als Alternative zu planaren Strukturen wurde das Wachstum von Quantenpunkten in Nanodrähten ("nanowires", NW) aus Mischhalbleitern, basierend auf Nitriden von Atomen der III. Hauptgruppe (Hauptgruppe III-Nitrid-Halbleiter), vorgeschlagen [4]. Die Verwendbarkeit derartiger Quantenpunkte als Lichtemitter, insbesondere als Einzelphotonenquellen, wurde mit ternären Mischhalbleitern bereits demonstriert. GaN-Quantenpunkte in (Al,Ga)N-Nanodrähten ergaben bei Raumtemperatur eine Emissionswellenlänge von 290 nm [2], während bei tiefen Temperaturen (In,Ga)N-Quantenpunkte in (Al,Ga)N-Nanodrähten mit einer Dicke im Bereich von 20 nm bis 30 nm bei 200 K mit einer Wellenlänge von 460 nm [5, 16] oder bei 150 K mit einer Wellenlänge von 520 nm [6] emittierten. Mit diesen Nanodraht-basierten Quantenpunkten wurden jedoch keine Lichtemitter erzielt, welche die oben genannten Anforderungen hinsichtlich der Betriebstemperatur und der Emissionswellenlänge in den Transmissionsfenstern gleichzeitig erfüllen.

In [7] wird die Bildung von mehreren Quantentöpfen in einem Nanodraht aus einem Nitrid-basierten Halbleiter mit einer Dicke oberhalb von 10 nm beschrieben. Die Quantentöpfe bilden Lichtemitter, deren Emissionseigenschaften durch die gezielte Wahl der Dicke des Nanodrahts und der axialen Höhe der Quantentöpfe eingestellt werden. Die Quantentöpfe sind jedoch keine Quantenpunkte, die zur Einzelphotonenemission geeignet wären.

Zur Herstellung von Nanodrähten sind nasschemische, Lösungsbasierte Verfahren bekannt. Diese erlauben zwar die Herstellung von Nanodrähten mit Dicken geringer als 10 nm. Sie sind jedoch für die Herstellung von Nitrid-basierten Nanodraht-Heterostrukturen ungeeignet. Alternativ können z. B. GaN-basierte Nanodrähte mit Epitaxieverfahren aus der Dampfphase gewachsen werden, wobei diese Verfahren auf Dicken bis oberhalb 10 nm beschränkt sind. Die Herstellung geringerer Dicken bis zu 5 nm wurde durch eine nachträgliche thermische Dekomposition von GaN in H₂ oder NH₃ erzielt [8]. Anwendungen der thermischen Dekomposition wurden jedoch bisher nicht beschrieben.

Halbleiter-basierte Lichtemitter mit GaN-basierten Nanodrähten und in diesen eingeschlossenen Quantentöpfen sind auch in [16] und [17] beschrieben. Diese Quantentöpfe haben jedoch Dimensionen, die kein dreidimensionales Ladungsträger-Confinement ermöglichen, so dass sie keine Quantenpunkte mit diskreten Energieniveaus (Zustandsdichte in Form einer Deltafunktion) bilden.

Die Aufgabe der vorliegenden Erfindung ist es, eine verbesserte lichtemittierende Halbleitereinrichtung bereitzustellen, mit der Nachteile herkömmlicher Techniken überwunden werden. Die lichtemittierende Halbleitereinrichtung soll insbesondere eine freie Wahl von Emissionseigenschaften, wie z. B. die Wellenlänge und/oder die Intensität des emittierten Lichts, und einen Betrieb bei Raumtemperatur ermöglichen. Die lichtemittierende Halbleitereinrichtung soll des Weiteren insbesondere zur Bereitstellung einer Einzelphotonenquelle geeignet sein, die bei einer Wellenlänge beispielsweise in einem Transmissionsfenster der verfügbaren optischen Datenkommunikationsgeräte emittiert. Eine weitere Aufgabe der Erfindung ist es, ein verbessertes Verfahren zur Herstellung einer lichtemittierenden Halbleitereinrichtung darzustellen, mit dem Nachteile herkömmlicher Techniken vermieden werden. Diese Aufgaben werden durch eine lichtemittierende Halbleitereinrichtung und ein Verfahren zu deren Herstellung mit den Merkmalen der unabhängigen Ansprüche gelöst. Vorteilhafte Ausführungsformen und Anwendungen der Erfindung ergeben sich aus den abhängigen Ansprüchen.

Gemäß einem ersten allgemeinen Gesichtspunkt der Erfindung wird die obige Aufgabe durch eine lichtemittierende Halbleitereinrichtung mit mindestens einem AlₓGa₁₋ₓN-basierten Nanodraht (Quantendraht) mit 0 ≤ x ≤ 1 gelöst, der mindestens einen InN-basierten Quantenpunkt, mit einen InN-Anteil oberhalb von 70 vol%, enthält und eine Dicke (Querschnittsdimension, Durchmesser) senkrecht zur Axialrichtung des Nanodrahts aufweist, die kleiner als 10 nm und kleiner oder gleich einer kritischen Dicke ist, die sich durch eine versetzungsfreie Verbindung des Quantenpunkts mit mindestens einem angrenzenden Nanodrahtabschnitt des Nanodrahts auszeichnet. Der mindestens eine Nanodraht, umfassend mindestens einen AlₓGa₁₋ₓN-basierten Nanodrahtabschnitt mit 0 ≤ x ≤ 1 und mindestens einen InN-basierten Quantenpunkt, ist vorzugsweise stehend oder liegend auf einem festen Substrat angeordnet.
Der Nanodraht ist kristallin, insbesondere bei Fehlen von Stapelfehlern in Axialrichtung vorzugsweise monokristallin. Mit der Erfindung wird die Tatsache ausgenutzt, dass jede Gitterfehlanpassung zwischen verbundenen Kristallen elastisch ausgeglichen werden kann, wenn die Verbindungsfläche zwischen den Kristallen ausreichend klein ist [9]. Die Erfinder haben festgestellt, dass für den mindestens einen GaN-basierten Nanodrahtabschnitt des Nanodrahts und den mindestens einen InN-basierten Quantenpunkt eine Dicke einstellbar ist, bei der die genannte Bedingung für einen elastischen Ausgleich der Fehlanpassung erfüllt ist und die als kritische Dicke bezeichnet wird. Wenn der Nanodraht eine Dicke aufweist, die kleiner oder gleich der kritischen Dicke ist, berühren sich der GaN-basierte Nanodrahtabschnitt und der InN-basierte Quantenpunkt mit einer gemeinsamen Kontaktfläche, die frei von Kristallfehlern, insbesondere Versetzungen ist.

Vorteilhafterweise ermöglicht die Bereitstellung des Nanodrahts mit dem mindestens einen Quantenpunkt die Kombination von AlₓGa₁₋ₓN - und InN-basierten Halbleitern, insbesondere von AlₓGa₁₋ₓN und InN, und damit die Schaffung eines Lichtemitters mit einer Lichtemission in einem erweiterten Wellenlängenbereich und einem starken Einschluss, so dass ein Betrieb bei Raumtemperatur (Temperatur T im Bereich von 270 K bis 300 K, insbesondere 295 K) oder darüber ermöglicht wird. Die Erfinder nutzen die elastische Spannungsrelaxation aus, die für Nanodraht-Heterostrukturen spezifisch ist, um die Beschränkung bei der Kombination von AlₓGa₁₋ₓN und InN in planaren Systemen zu überwinden. Hierdurch werden kohärent verspannte InN-basierte Quantenpunkte realisiert, die in AlₓGa₁₋ₓN-basierten Nanodrähten angeordnet sind. Diese Nanodraht-Heterostruktur ergibt ein dreidimensionales, atomähnliches Quanten-Confinement, wie es für die Einstellbarkeit Einzelphotonenquellen und für die Raumtemperatur-Einzelphotonenemission erforderlich ist.

Der Nanodraht kann entlang seiner Axialrichtung (Längsrichtung) und mit einem kreisförmigen Querschnitt in allen Radialrichtungen eine konstante Dicke aufweisen, die erfindungsgemäß kleiner oder gleich der kritischen Dicke ist. Alternativ kann der Nanodraht entlang seiner Axialrichtung und/oder in den Radialrichtungen verschiedene Dicken aufweisen. Der Nanodraht kann zum Beispiel einen Dickengradienten in Axialrichtung mit einer Verjüngung von einem dickeren Ende zu einem dünneren Ende des Nanodrahts aufweisen. Des Weiteren kann der Nanodraht einen nicht-kreisförmigen, z. B. elliptischen oder polygonalen, Querschnitt in Radialrichtung aufweisen. In diesen Fällen ist die Dicke des Nanodrahts an den Grenzflächen zwischen dem Nanodrahtabschnitt und dem Quantenpunkt erfindungsgemäß kleiner oder gleich der kritischen Dicke.

Die kritische Dicke des Nanodrahts, welche die versetzungsfreie Verbindung der aneinander grenzenden AlₓGa₁₋ₓN- und InN-basierten Kristalle ermöglicht, kann durch theoretische Betrachtungen, basierend auf den elastischen Eigenschaften der Kristalle, oder durch empirische Tests ermittelt werden. Vorzugsweise ist die einheitliche Dicke des Nanodrahts mit dem mindestens einen Quantenpunkt oder die Dicke des Nanodrahts an der Grenzfläche zwischen dem Nanodrahtabschnitt und dem Quantenpunkt kleiner als 10 nm, besonders bevorzugt kleiner als 8 nm. Vorteilhafterweise ermöglicht der Nanodraht mit dieser Dicke eine freie Kombination von AlₓGa₁₋ₓN-basierten Nanodrahtabschnitten und InN-basierten Nanodrahtabschnitten, die jeweils einen Quantenpunkt bilden, so dass die Emissionseigenschaften der lichtemittierenden Halbleitereinrichtung durch die Dimensionierung des Nanodrahts und insbesondere von dessen Dicke und/oder der Höhe des mindestens einen Quantenpunkts entlang der Axialrichtung des Nanodrahts einstellbar sind. Eine untere Begrenzung der Dicke der Halbleiterdrähte ist durch die Herstellungsbedingungen und die mechanische Stabilität des Nanodrahts auf dem Substrat gegeben. Ein Nanodraht hat typischerweise eine Dicke D, die größer oder gleich 2 nm ist.

Vorteilhafterweise bestehen verschiedene Möglichkeiten, den Nanodraht mit dem mindestens einen Quantenpunkt zu konfigurieren. Gemäß einer bevorzugten Ausführungsform der Erfindung sind mindestens zwei AlₓGa₁₋ₓN-basierte Nanodrahtabschnitte vorgesehen, wobei der mindestens eine Quantenpunkt entlang der Axialrichtung des Nanodrahts beidseitig von zwei der mindestens zwei Nanodrahtabschnitte begrenzt ist. Jeweils ein Quantenpunkt des Nanodrahts wird in diesem Fall beidseitig von AlₓGa₁₋ₓN-basierten Nanodrahtabschnitten eingeschlossen. Vorteilhafterweise wird damit die Bildung einer Halbleiterdiode für eine elektrische Anregung des Lichtemitters erreicht. Alternativ besteht die Möglichkeit, dass der Nanodraht nur einen AlₓGa₁₋ₓN-basierten Nanodrahtabschnitt und einen einzigen Quantenpunkt am freien Ende des AlₓGa₁₋ₓN-basierten Nanodrahtabschnittes aufweist. Auch bei dieser Variante der Erfindung bildet der Nanodraht einen Lichtemitter, insbesondere einen Einzelphotonenemitter. Des Weiteren können Nanodrahtabschnitte mit eingebetteten Quantenpunkten und einem Quantenpunkt am freien Ende des Nanodrahts vorgesehen sein.

Der mindestens eine Quantenpunkt des erfindungsgemäßen Lichtemitters ist ein InN-basierter Nanodrahtabschnitt. Der InN-basierte Kristall des Quantenpunkts wird in axialer Richtung mindestens einseitig von dem AlₓGa₁₋ₓN-basierten Nanodrahtabschnitt begrenzt. In radialer Richtung kann der InN-basierte Kristall des Quantenpunkts freiliegen. In diesem Fall können sich Vorteile für die Herstellung des Lichtemitters ergeben. Gemäß einer alternativen Variante der Erfindung kann der mindestens eine Quantenpunkt auch in Radialrichtung von einem AlₓGa₁₋ₓN-basierten Halbleiter mit 0 ≤ x ≤ 1 bedeckt sein. Vorteilhafterweise wird in diesem Fall die Oberflächenrekombination angeregter Ladungsträgerpaare verringert.

Die chemische Zusammensetzung des Nanodrahts wird durch die Prozessbedingungen bei der Herstellung des Nanodrahts bestimmt. Der Begriff "AlₓGa₁₋ₓN-basierter Nanodrahtabschnitt" bezieht sich allgemein auf einen Bereich des Nanodrahts entlang dessen Axialrichtung, der vorzugsweise vollständig aus GaN, AlN oder einem AlGaN-Mischhalbleiter besteht oder alternativ einen Anteil von GaN und/oder AlN oberhalb von 70 vol% aufweist und im Übrigen z. B. InN enthält. Der Begriff "InN-basierter Quantenpunkt" bezieht sich allgemein auf einen Bereich des Nanodrahts, der vollständig aus InN besteht oder einen InN-Anteil oberhalb von 70 vol% aufweist und im Übrigen z. B. GaN oder AlN enthält.

Es bestehen mehrere Möglichkeiten, die Zusammensetzung des Nanodrahts zu wählen. Vorteilhafterweise können durch die Wahl der Zusammensetzung des mindestens einen AlₓGa₁₋ₓN-basierten Nanodrahtabschnitts und des mindestens einen InN-basierten Quantenpunkts die Energieniveaus im Quantenpunkt und entsprechend Emissionseigenschaften des Lichtemitters eingestellt werden. Gemäß einer bevorzugten Ausführungsform der Erfindung besteht der AlₓGa₁₋ₓN-basierte Nanodrahtabschnitt ausschließlich aus GaN. Alternativ kann der AlₓGa₁₋ₓN-basierte Nanodrahtabschnitt zusätzlich zu GaN zum Beispiel AlN, InN und/oder Dotierstoffe enthalten. Beispielsweise kann der AlₓGa₁₋ₓN-basierte Nanodrahtabschnitt einen InN-Anteil enthalten, der geringer als 20 vol%, insbesondere geringer als 10 vol% ist.

Gemäß einer weiteren bevorzugten Ausführungsform der Erfindung besteht der mindestens eine Quantenpunkt ausschließlich aus InN. Vorteilhafterweise besteht in diesem Fall der Quantenpunkt aus einem binären Halbleiter, der im Vergleich zu einem ternären Halbleiter einfacher herstellbar ist.

Die Erfinder haben allerdings festgestellt, dass der InN-basierte Quantenpunkt einen Ga-Anteil aufweisen kann. Beispielsweise können Ga-Atome, die stärker als In-Atome mit N-Atomen binden, durch Austauschreaktionen in den InN-basierten Quantenpunkt einwandern, ohne dass die Funktion des Lichtemitters beeinträchtigt wird. Vorzugsweise besteht der mindestens eine Quantenpunkt aus InN mit einem derart geringen Ga-Anteil, dass eine Energiedifferenz zwischen dem niedrigsten gebundenen Energieniveau von Elektronen im Quantenpunkt und dem ersten angeregten Energieniveau der Elektronen (gebundener Zustand oder Kontinuumszustand) größer als thermische Energiefluktuationen von Ladungsträgern im Quantenpunkt bei Raumtemperatur sind. Der Ga-Anteil ist im Quantenpunkt geringer als 10 vol-%, insbesondere geringer als 5 vol-%. Vorteilhafterweise bietet ein InN-basierter Quantenpunkt mit einem derart geringen Ga-Anteil einen ausreichend starken Einschluss, dass eine gezielte, durch ein Auslösesignal gesteuerte Lichtemission bei Raumtemperatur, insbesondere für eine Einzelphotonenemission, ermöglicht wird.
Vorteilhafterweise ist die Emissionswellenlänge des mindestens einen Quantenpunkts durch die Höhe des Quantenpunkts in Axialrichtung des Nanodrahts bestimmt. Vorzugsweise wird die Höhe des mindestens einen Quantenpunkts derart gewählt, dass eine exzitonische Übergangsenergie zwischen einem niedrigsten Energieniveau eines Elektrons und einem höchsten Energieniveau eines Lochs in dem Quantenpunkt gleich einer Energie von Photonen in einem Wellenlängenbereich von 400 nm bis 3 µm ist. Für diesen Wellenlängenbereich ist die Höhe des Quantenpunkts in Axialrichtung gemäß der Erfindung im Bereich von 0.3 nm bis 3 nm gewählt.

Besonders bevorzugt, insbesondere für die Anwendung als Einzelphotonenquelle, weist der Quantenpunkt in Axialrichtung eine derartige Höhe auf, dass die exzitonische Übergangsenergie zwischen dem niedrigsten Energieniveau eines Elektrons und dem höchsten Energieniveaus eines Lochs im Quantenpunkt gleich einer Energie von Photonen bei einer Wellenlänge von 1,3 µm oder 1,55 µm ist. Vorteilhafterweise wird damit eine Lichtemission in den genannten Transmissionsfenstern der verfügbaren optischen Datenübertragung erzielt. Für die genannten Wellenlängen ist die Höhe des Quantenpunkts in Axialrichtung vorzugsweise im Bereich von 1.2 nm bis 1.5 nm bzw. im Bereich von 1.5 nm bis 1.8 nm gewählt.

Vorteilhafterweise bestehen verschiedene Anwendungen der erfindungsgemäßen lichtemittierenden Halbleitereinrichtung. Gemäß einer ersten Variante der Erfindung stellt die lichtemittierende Halbleitereinrichtung einen Mehrphotonen-Lichtemitter, z. B. für Anwendungen in der Optoelektronik, der Messtechnik oder der Beleuchtungstechnik dar. In diesem Fall umfasst der Nanodraht vorzugsweise eine Vielzahl von InN-basierten Quantenpunkten, die in Axialrichtung des Nanodrahts durch AlₓGa₁₋ₓN-basierte Nanodrahtabschnitte voneinander getrennt angeordnet sind. In Reaktion auf eine Anregung der Ladungsträger in den Quantenpunkten, z. B. durch eine elektrische und/oder optische Anregungsquelle, werden von der lichtemittierenden Halbleitereinrichtung eine Vielzahl von Photonen emittiert.

Gemäß einer zweiten, besonders vorteilhaften Variante der Erfindung weist die lichtemittierende Halbleitereinrichtung einen einzigen Nanodraht mit einem einzigen Quantenpunkt auf. In diesem Fall ist die Halbleitereinrichtung so konfiguriert, dass in Reaktion auf die Anregung der Ladungsträger in dem Quantenpunkt ein einziges Photon emittiert wird. Vorteilhafterweise bildet bei dieser Variante der Erfindung die lichtemittierte Halbleitereinrichtung einen Einzelphotonen-Lichtemitter, insbesondere für Anwendungen bei der optischen Datenübertragung.

Weitere Merkmale, die einzeln oder in Kombination realisiert werden können und von besonderem Vorteil für die Anwendung der lichtemittierenden Halbleitereinrichtung in der Optoelektronik oder der optischen Datenübertragung sind, beziehen sich auf die Ausrichtung des mindestens einen Nanodrahts auf dem Substrat, die Bereitstellung von mindestens einer elektrischen oder optischen Anregungseinrichtung und/oder die Bereitstellung eines optischen Elements zur Einkopplung von Photonen aus dem Lichtemitter, insbesondere aus dem mindestens einen Quantenpunkt, in einen Lichtwellenleiter. Beispielsweise kann der mindestens eine Nanodraht aufrecht stehend auf dem Substrat positioniert sein. Die Axialrichtung kann sich beispielsweise senkrecht zur Substratoberfläche oder gegenüber der Senkrechten geneigt erstrecken. Alternativ kann sich die Axialrichtung des mindestens einen Nanodrahts entlang der Oberfläche des Substrats, d. h. parallel zur vorzugsweise ebenen Substratoberfläche, erstrecken. Der mindestens eine Nanodraht kann z. B. auf der Oberfläche des Substrats oder einer Zwischenschicht liegend angeordnet sein. In diesem Fall können sich Vorteile für die elektrische oder optische Anregung des mindestens einen Quantenpunkts und die mechanische Stabilität des Nanodrahts ergeben.

Vorteilhafterweise kann die Anregungseinrichtung Elektroden umfassen, über welche der Nanodraht mit einer elektrischen Anregungsquelle gekoppelt ist und die zur elektrischen Anregung der Ladungsträger im Quantenpunkt angeordnet sind. Alternativ kann die Anregungseinrichtung eine Lichtquelle, wie z. B. eine herkömmliche Laserdiode umfassen, die zur optischen Anregung der Ladungsträger im Quantenpunkt angeordnet ist. Die Anregungseinrichtung, insbesondere die Elektroden und/oder die Laserdiode, können gemeinsam mit dem mindestens einen Nanodraht auf der Oberfläche des Substrats positioniert sein.

Das optische Element zur Einkopplung von Photonen aus dem Quantenpunkt in einen Lichtwellenleiter ist vorzugsweise ein Reflektorelement, das wie z. B. ein Konkavspiegel wirkt, und/oder ein fokussierendes Element, das z. B. wie eine Linse wirkt.

Gemäß einem zweiten allgemeinen Gesichtspunkt der Erfindung wird die oben genannte Aufgabe durch ein Verfahren zur Herstellung der erfindungsgemäßen lichtemittierenden Halbleitereinrichtung gelöst, das die folgenden Schritte aufweist. Zunächst erfolgt die Bildung mindestens eines drahtförmigen, AlₓGa₁₋ₓN-basierten Nanodrahtabschnitts mit 0 ≤ x ≤ 1. Die Bildung des Nanodrahtabschnitts erfolgt vorzugsweise auf einem Substrat, ist aber auch substratfrei möglich (Aerotaxie-Verfahren). Vorzugsweise wird eine Vielzahl von Nanodrahtabschnitten insbesondere gleichzeitig gebildet, von denen mindestens ein Nanodrahtabschnitt für die weitere Herstellung der erfindungsgemäßen lichtemittierenden Halbleitereinrichtung verwendet wird. Alternativ kann ein einziger Nanodrahtabschnitt gebildet werden. Anschließend erfolgt das Wachstum eines Quantenpunkts auf einem freien Ende des mindestens einen Nanodrahtabschnitts. Des Weiteren ist erfindungsgemäß eine thermische Dekomposition des AlₓGa₁₋ₓN derart vorgesehen, dass der Nanodrahtabschnitt, zumindest entlang der Grenzfläche zum Quantenpunkt, eine Dicke kleiner oder gleich der kritischen Dicke aufweist. Die thermische Dekomposition umfasst ein Abdünnen des Nanodrahts, das vor der Bildung des Quantenpunkts oder alternativ nach der Bildung des Quantenpunkts, d. h. am Verbund aus Nanodrahtabschnitt und Quantenpunkt, vorgesehen sein kann.

Gemäß einer Ausführungsform der Erfindung wird am freien Ende des Nanodrahtabschnitts ein einziger Quantenpunkt aufgewachsen. Alternativ erfolgt anschließend das abwechselnde epitaktische Aufwachsen von mindestens einem weiteren AlₓGa₁₋ₓN-basierten Nanodrahtabschnitt und mindestens einem weiteren InN-basierten Quantenpunkt derart, dass am freien Ende des Nanodrahts ein AlₓGa₁₋ₓN-basierter Nanodrahtabschnitt oder ein InN-basierter Quantenpunkt angeordnet ist.

Vorteilhafterweise bestehen verschiedene Ausführungsformen der Bildung des mindestens einen Nanodrahtabschnitts. Vorzugsweise werden dabei an sich bekannte Abscheidungs- oder Wachstumsverfahren, wie z. B. MBE-, MOCVD- und/oder MOVPE-Verfahren angewendet. Gemäß einer ersten Variante (bottom-up-Verfahren) erfolgt ein Wachstum des Nanodrahtabschnitts und ein nachfolgendes epitaktisches Wachstum des Quantenpunkts auf dem Nanodrahtabschnitt. Das Wachstum des Nanodrahtabschnitts kann auf einem Substrat oder ohne Substrat erfolgen. Gemäß einer alternativen, zweiten Variante (top-down-Verfahren) erfolgt eine Abscheidung einer AlₓGa₁₋ₓN-basierten Schicht auf einem Substrat und einer InN-basierten Schicht auf der AlₓGa₁₋ₓN-basierten Schicht mit einem nachfolgenden selektiven Ätzen der Schichten derart, dass der Nanodrahtabschnitt mit dem Quantenpunkt gebildet wird. Das top-down-Verfahren zeichnet sich vorteilhafterweise durch identische Nanodrahtabschnitte und Quantenpunkte in allen Nanodrähten aus. Obwohl die planare Abscheidung der Schichten zunächst Versetzungen an den Grenzflächen zwischen den Nanodrahtabschnitten und den Quantenpunkten erzeugen, sind diese Versetzungen nach dem Ätzen und Abdünnen der Nanodrahtabschnitte auf die Dicke kleiner oder gleich der kritischen Dicke ausgeheilt oder durch das Abdünnen beseitigt.

Besonders bevorzugt erfolgt eine Einstellung einer Emissionswellenlänge der Halbleitereinrichtung durch eine Einstellung der Höhe des mindestens einen Quantenpunkts entlang der Axialrichtung des Nanodrahts und/oder der Dicke des Nanodrahts. Weitere Einzelheiten und Vorteile der Erfindung werden im Folgenden unter Bezug auf die beigefügten Zeichnungen beschrieben. Es zeigen:
- Figur 1:: schematische Schnittansichten verschiedener Varianten eines Nanodrahts einer erfindungsgemäßen lichtemittierenden Halbleitereinrichtung;
- Figur 2:: schematische Illustrationen verschiedener Varianten einer Anregungseinrichtung und eines optischen Elements;
- Figur 3:: eine schematische Illustration der thermischen Dekomposition eines Nanodrahts;
- Figur 4:: elektronenmikroskopische Ansichten verschiedener Varianten von Nanodrähten, die für erfindungsgemäße lichtemittierende Halbleitereinrichtungen vorgesehen sind; und
- Figuren 5 bis 9:: Kurvendarstellungen zur Charakterisierung von mechanischen Spannungseigenschaften und Emissionseigenschaften von Nanodrähten erfindungsgemäßer lichtemittierender Halbleitereinrichtungen.

Merkmale bevorzugter Ausführungsformen der erfindungsgemäßen lichtemittierenden Halbleitereinrichtung und des Verfahrens zu deren Herstellung werden im Folgenden insbesondere unter Bezug auf die geometrische Dimensionierung des Nanodrahts mit dem mindestens einen AlₓGa₁₋ₓN-basierten Nanodrahtabschnitt und dem mindestens einen InN-basierten Quantenpunkt beschrieben. Einzelheiten der Verfahren zum Wachstum von Nanodrähten mittels Epitaxie aus der Dampfphase werden hier nicht beschrieben, da diese an sich aus dem Stand der Technik bekannt sind. Es wird betont, dass die erfindungsgemäße geometrische Dimensionierung des Nanodrahts mit herkömmlichen Techniken zur Einstellung von optischen, elektrischen, mechanischen und/oder thermischen Eigenschaften von Halbleitermaterialien, z. B. durch eine Änderung der Zusammensetzung und/oder eine Dotierung, kombiniert werden kann. Es ist insbesondere möglich, den mindestens einen AlₓGa₁₋ₓN-basierten Nanodrahtabschnitt und den mindestens einen InN-basierten Quantenpunkt mit Dotierstoffen, wie z. B. Si oder Mg zu dotieren, wie es an sich aus dem Stand der Technik bekannt ist.

Die Erfindung wird im Folgenden unter beispielhaftem Bezug auf Mehrphotonen- oder Einzelphotonen-Lichtemitter beschrieben, bei denen eine einzige Nanosäule auf einem Substrat angeordnet ist. Es wird betont, dass die Erfindung in entsprechender Weise durch Ausführungsformen realisiert werden kann, bei denen eine Vielzahl von Nanosäulen, jeweils mit einem Quantenpunkt oder mehreren Quantenpunkten stehend oder liegend auf einem gemeinsamen Substrat oder mehreren Substraten angeordnet ist. Die Anzahl der Nanosäulen auf einem Substrat kann z. B. im Bereich von 10 bis 10⁷ gewählt sein. Es kann insbesondere eine regelmäßige Anordnung, z. B. in Gestalt einer Matrix mit geraden Zeilen und Spalten, oder eine unregelmäßige Anordnung der Nanosäulen auf dem Substrat vorgesehen sein. Wenn mehrere Nanosäulen auf dem Substrat angeordnet sind, können für alle Nanosäulen eine gemeinsame Anregungseinrichtung oder für jede Nanosäule eine zugehörige separate Anregungseinrichtung vorgesehen sein.

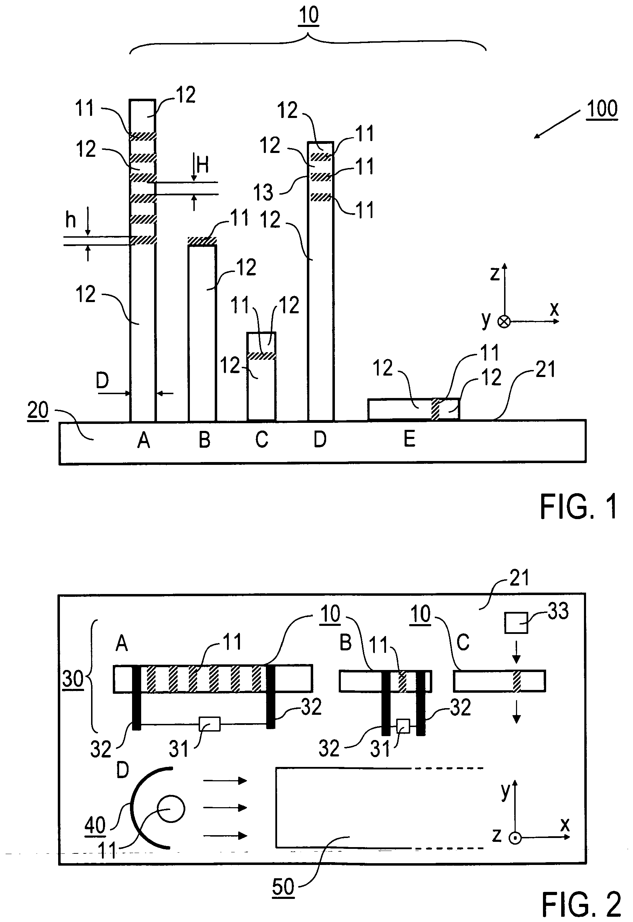

Figur 1 illustriert in schematischer, nicht maßstabgerechter Schnittansicht verschiedene Varianten von Nanodrähten 10, die auf einem Substrat 20 angeordnet sind. Jeweils mindestens ein Nanodraht 10 auf dem Substrat 20 bildet eine Ausführungsform einer erfindungsgemäßen lichtemittierenden Halbleitereinrichtung 100. Das Substrat 20 ist eine Platte, die z. B. aus einer Keramik oder einem Halbleitermaterial, wie beispielsweise Si hergestellt ist und eine ebene Substratoberfläche 21 aufweist. Gemäß dem beispielhaft gezeigten Koordinatensystem erstreckt sich die Substratoberfläche 21 in einer x-y-Ebene senkrecht zur Zeichenebene. Die Nanodrähte 10 haben eine langgestreckte Draht- oder Säulenform mit einer Axialrichtung, die mit der z-Richtung zusammenfällt (Nanodrähte 10 stehen senkrecht auf der Substratoberfläche 21, Figuren 1A bis 1D), gegenüber der z-Richtung geneigt sind (nicht dargestellt) oder senkrecht zur z-Richtung verlaufen (Nanodrähte 10 liegen auf der Substratoberfläche 21, Figur 1E).

Die Nanodrähte 10 haben senkrecht zur Axialrichtung z. B. eine kreisrunde, ellipsenförmige oder polygonale Querschnittsform mit einer charakteristischen Querschnittsdimension (Dicke, Druckmesser) D, deren maximaler Wert geringer als die kritische Dicke zur Bildung einer versetzungsfreien Heterostruktur aus AlₓGa₁₋ₓN- und InN-basierten Nanodrahtabschnitten ist. Bei den dargestellten Beispielen ist die Dicke der Nanodrähte 10 geringer als 10 nm, beispielsweise ≤ 8 nm oder < 6 nm. Die Länge der Nanodrähte 10 in Axialrichtung ist beispielsweise im Bereich von 200 nm bis 5 µm gewählt.

Gemäß Figur 1A umfasst der Nanodraht 10 AlₓGa₁₋ₓN-basierte Nanodrahtabschnitte 12 und InN-basierte Quantenpunkte 11 (schraffiert dargestellt). Im dargestellten Beispiel sind sechs Quantenpunkte 11 vorgesehen, die jeweils eine Höhe h in Axialrichtung mit h = 1.8 nm aufweisen und durch AlₓGa₁₋ₓN-basierte Nanodrahtabschnitte 12 mit einer Höhe H in Axialrichtung mit H = 20 nm getrennt sind. Die Nanodrahtabschnitte 12 bestehen z. B. ausschließlich aus GaN, während die Quantenpunkte 11 z. B. ausschließlich aus InN bestehen. Mit der beispielhaft angegebenen Höhe h ist eine lichtemittierende Halbleitereinrichtung 100 mit dem Nanodraht 10 für eine Emission bei 1550 nm ausgelegt.

Gemäß den Figuren 1B und 1C enthält der Nanodraht 10 jeweils einen einzigen Quantenpunkt 11, der am oberen Ende des AlₓGa₁₋ₓN-basierten Nanodrahtabschnittes 12 angeordnet (Figur 1B) oder zwischen zwei AlₓGa₁₋ₓN-basierten Nanodrahtabschnitten 12 eingebettet (Figur 1C) ist.

Figur 1D zeigt eine weitere Variante eines Nanodrahts 10 mit mehreren Quantenpunkten 11, die zwischen AlₓGa₁₋ₓN-basierten Nanodrahtabschnitten 12 eingebettet sind und zusätzlich allseits in Radialrichtung eine AlₓGa₁₋ₓN-basierte Deckschicht 13 tragen. Die Deckschicht 13 hat eine Dicke von z. B. 1 nm.

Figur 1E illustriert die Variante des Nanodrahts 10 mit zwei AlₓGa₁₋ₓN-basierten Nanodrahtabschnitten 12 und einem einzigen, eingebetteten Quantenpunkt 11, wobei der Nanodraht 10 auf der Substratoberfläche 21 aufliegt. Die anderen Varianten der Nanodrähte 10 mit einem oder mehreren Quantenpunkten 11 können in gleicher Weise auf der Substratoberfläche 21 liegend bereitgestellt werden.

Die Anregung einer Lichtemission aus dem mindestens einen Quantenpunkt 11 eines Nanodrahts 10 erfolgt mit einer elektrischen und/oder einer optischen Anregungseinrichtung 30, die im Folgenden unter Bezug auf die Figuren 2A bis 2C beschrieben wird.

Die Figuren 2A und 2B illustrieren jeweils einen Nanodraht 10 mit sechs Quantenpunkten 11 (Figur 2A) oder einem einzigen Quantenpunkt 11 (Figur 2B), die liegend auf der Substratoberfläche 21 angeordnet sind. Zur elektrischen Anregung der Lichtemission aus den Quantenpunkten 11 ist die Anregungseinrichtung 30 in Gestalt einer schaltbaren Spannungsquelle 31 vorgesehen, die über Elektroden 32 mit dem Nanodraht 10 verbunden ist. Die Elektroden 32 sind mit einem Abstand in Axialrichtung des Nanodrahts 10 so angeordnet, dass der mindestens eine Quantenpunkt 11 zwischen den Elektroden 32 eingeschlossen ist. Die Elektroden 32 umfassen z. B. streifenförmige Schichten aus einem Metall (beispielsweise ein Schichtverbund aus Ti/Al) mit einer Breite von 50 µm und einer Dicke von 200 nm, die mit einem lithographischen Abscheidungsverfahren aus der Dampfphase hergestellt sind.

Zum Auslösen einer Lichtemission erzeugt die Spannungsquelle 31 einen elektrischen Anregungsimpuls, unter dessen Wirkung in dem mindestens einen Quantenpunkt 11 Elektron-Loch-Paare angeregt wird, wobei anschließend der Quantenpunkt 11 unter Aussendung von mehreren Photonen oder einem einzigen Photon in den Grundzustand zurückkehrt.

Gemäß Figur 2C umfasst die Anregungseinrichtung 30 eine Lichtquelle 33, wie z. B. eine Laserdiode, die zur Beleuchtung des mindestens einen Quantenpunkts 11 auf der Substratoberfläche 21 angeordnet ist. Zum Auslösen einer Lichtemission aus dem Quantenpunkt 11 wird die Lichtquelle 33 pulsförmig angesteuert, so dass eine optische Anregung eines Ladungsträger-Loch-Paares im Quantenpunkt 11 und anschließend die Rücckehr in den Grundzustand unter Aussendung von mehreren Photonen oder einem einzigen Photon erfolgt.

Während die Figuren 2A bis 2C die Anregungseinrichtung 30 mit einer liegenden Konfiguration der Nanodrähte 10 schematisch illustrieren, kann die Anregungseinrichtung 30 für eine elektrische und/oder optische Anregung des mindestens einen Quantenpunkts in einem stehenden Nanodraht entsprechend angepasst werden. Für die elektrische Kontaktierung kann der Nanodraht 10 beispielsweise in eine elektrisch-isolierende Schicht, z. B. aus einem Polymer eingebettet sein, welche zwei Elektroden zur elektrischen Anregung des mindestens einen Quantenpunkts 11 trägt. Zur optischen Anregung kann die Lichtquelle 33, wie in Figur 2C gezeigt, auf der Substratoberfläche 21 neben einem stehenden Nanodraht 10 angeordnet sein.

Figur 2D illustriert schematisch ein optisches Element 40 mit der Funktion eines Konkav-Spiegels zur optischen Kopplung des Nanodrahts 10 mit einem Lichtleiter 50. Mit dem optischen Element 40 wird das von einem Quantenpunkt 11 emittierte Licht gesammelt und, gegebenenfalls unter Verwendung einer fokussierenden Linse (nicht dargestellt), auf einen Eingang des Lichtwellenleiters 50 gerichtet. Es wird betont, dass Figur 2D eine schematische Darstellung des optischen Elements enthält. In der praktischen Anwendung sind die Dimensionen des optischen Elements derart gering, dass die Kopplung nicht mehr strahlenoptisch beschrieben werden und das optische Element 40 eine von einem makroskopischen Konkavspiegel abweichende Gestalt aufweisen kann.

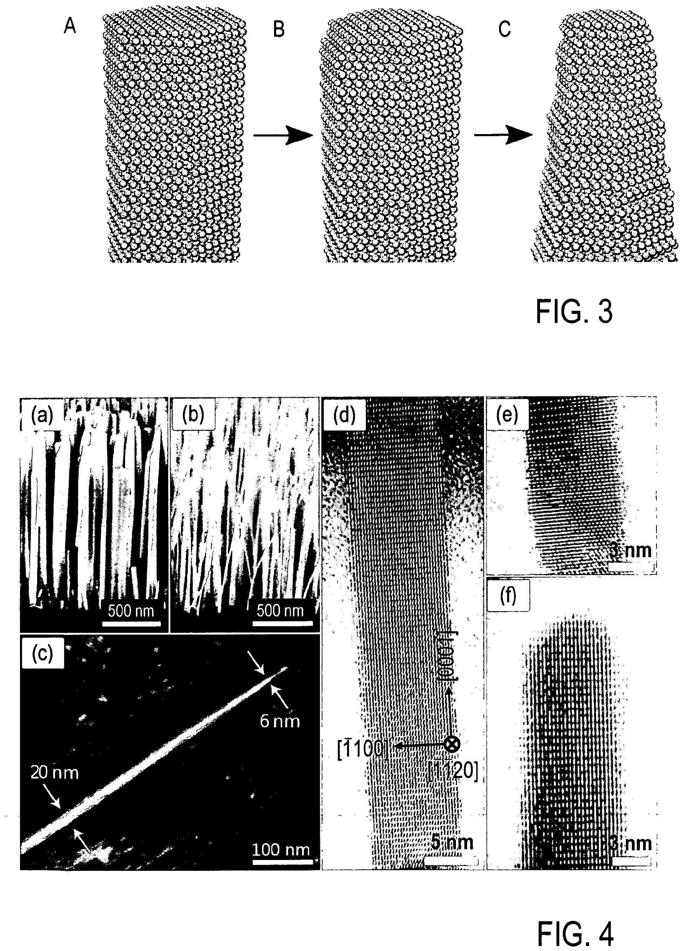

Die Herstellung einer erfindungsgemäßen lichtemittierenden Halbleitereinrichtung 100, z. B. gemäß Figur 1, umfasst beim bottom-up-Verfahren die folgenden Schritte. Zunächst erfolgt das Wachstum von einem oder mehreren GaN-Nanodrähten 10 auf der freien Oberfläche 21 eines Substrats 20, z. B. mit einem MBE-, MOCVD- oder MOVPE-Verfahren. Das Wachstum erfolgt z. B. durch eine epitaktische Abscheidung aus der Dampfphase, wie z. B. in [15] beschrieben ist. Im Ergebnis wird ein säulenförmiger GaN-Kristall gebildet, dessen freies oberes Ende beispielhaft in Figur 3A illustriert ist. Alternativ ist ein substratfreies Wachstum möglich, insbesondere durch Anwendung von Aerotaxie-Verfahren.

Anschließend erfolgt die thermische Dekomposition des GaN-Kristalls im Vakuum oder in Gegenwart von N₂ basierend auf der in [8] beschriebenen Verfahrensweise. Die thermische Dekomposition erfolgt, indem GaN beginnend vom freien Ende des GaN-Kristalls (Figur 3B) schichtweise abgetragen wird. Die Dekomposition umfasst eine Abtragung entsprechend den Kristallebenen (Figur 3C), bis ein Basis-Nanodrahtabschnitt mit der gewünschten Dicke gleich oder kleiner der kritischen Dicke des Nanodrahts erreicht ist. Dies wird erfindungsgemäß durch eine Beobachtung der Nanodrähte während der Dekomposition festgestellt und kann optional durch Referenzmessungen vorgegeben werden. Die Abtragsrate der thermischen Dekomposition wird über die Substrattemperatur gesteuert, die beispielsweise im Bereich von 900 °C bis 930 °C gewählt ist. Die Dauer der thermischen Dekomposition beträgt z. B. 30 min.

Das Ergebnis der thermischen Dekomposition ist mit den elektronenmikroskopischen Bildern der Figuren 4A und 4B gezeigt. Die Dicke der GaN-Kristalle wird von z. B. 50 nm (Figur 4A) auf z. B. 8 nm (Figur 4D - 4F) reduziert. Da der Abtrag von GaN schichtweise am freien Ende des GaN-Kristalls beginnend erfolgt, weist der Nanodraht 10 nach der thermischen Dekomposition eine konische Form auf, wie in der elektronenmikroskopischen Abbildung der Figur 4C gezeigt ist. Die konische Verjüngung des Nanodrahts 10 hin zu seinem freien Ende ist in der Praxis abweichend von der Schemadarstellung von Figur 3C jedoch so geringfügig, dass sie für die Funktion der lichtemittierenden Halbleitereinrichtung vernachlässigbar ist.

Die Figuren 4D bis 4F zeigen weitere Beispiele von GaN-Nanodrähten, die mit dem Transmissions-Elektronenmikroskop aufgenommen wurden. Der Nanodraht gemäß Figur 4D zeigt in Dickenrichtung rund 32 Atomlagen, was einem Durchmesser von rund 9 nm entspricht. Der Nanodraht gemäß Figur 4E hat eine Dicke von rund 6 nm. Figur 4F zeigt das freie Ende des Nanodrahts gemäß Figur 4D.

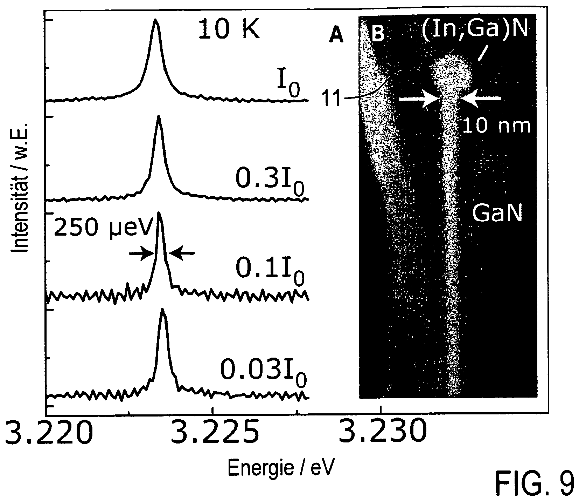

Anschließend wird auf dem freien Ende des Nanodrahts 10 (erster Nanodrahtabschnitt) ein InN-basierter Nanodrahtabschnitt zur Bildung des ersten oder einzigen Quantenpunkts epitaktisch aus der Dampfphase abgeschieden. Die Höhe des Quantenpunkts 11 (siehe z. B. Figur 9B) wird in Abhängigkeit von der gewünschten Emissionswellenlänge des vom Quantenpunkt emittierten Lichts gewählt und beträgt z. B. 1.8 nm.

In Abhängigkeit von der gewünschten Konfiguration des Nanodrahts 10 (siehe z. B. Figur 1) können weitere Schritte der abwechselnden Abscheidung von AlₓGa₁₋ₓN-basierten Nanodrahtabschnitten und InN-basierten Quantenpunkten folgen. Des Weiteren können nach dem vollständigen Wachstum des Nanodrahts mit der gewünschten Konfiguration weitere Schritte zur Fertigstellung der lichtemittierenden Halbleitereinrichtung, insbesondere die Ablage von mindestens einem Nanodraht auf einem Substrat, eine Kontaktierung mit Elektroden und/oder eine Bereitstellung einer optischen Anregungsquelle, folgen.

Die Herstellung einer erfindungsgemäßen lichtemittierenden Halbleitereinrichtung 100, z. B. gemäß Figur 1, umfasst beim top-down-Verfahren z. B. eine MOCVD- oder MOVPE-Abscheidung der AlₓGa₁₋ₓN-basierten Schicht auf dem Substrat und anschließend z. B. eine MBE -Abscheidung der InN-basierten Schicht auf der AlₓGa₁₋ₓN-basierten Schicht. Die Abscheidungsverfahren werden mit an sich bekannten Techniken realisiert. Zur Bildung der Nanodrahtabschnitte jeweils mit einem Quantenpunkt erfolgt ein selektives Ätzen der Schichten z. B. mittels Ionenstrahlätzen. Die thermische Dekomposition erfolgt, wie oben zum bottom-up-Verfahren beschrieben ist.

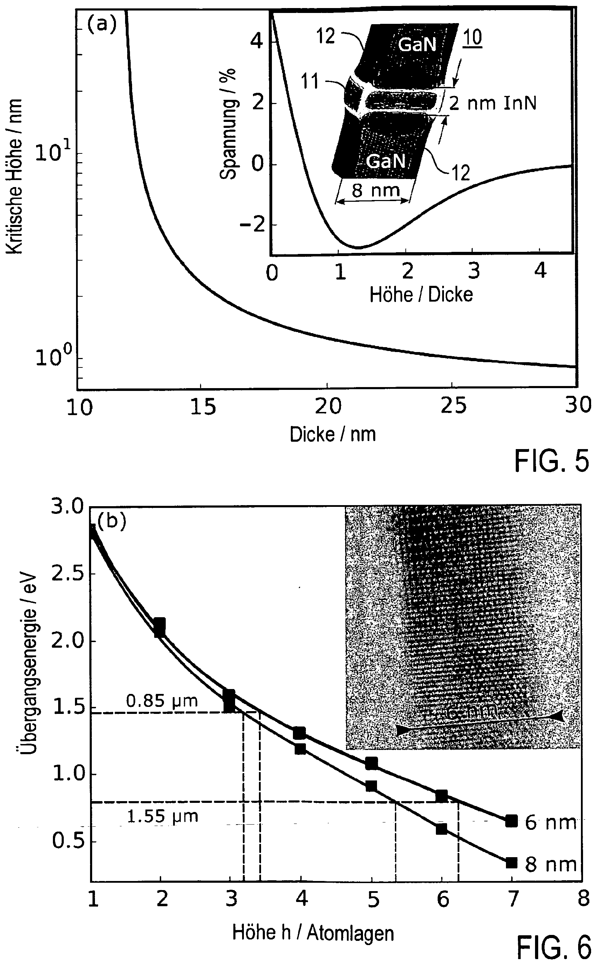

Unter Bezug auf die Figuren 5 bis 9 werden weitere theoretische und experimentelle Ergebnisse der Erfinder zur Charakterisierung der Nanodrähte erfindungsgemäßer lichtemittierender Halbleitereinrichtungen beschrieben.

Die kritische Dicke des Nanodrahts, bei der oder unterhalb derer die verschiedenen Kristalle des AlₓGa₁₋ₓN-basierten Nanodrahtabschnitts und des InN-basierten Quantenpunkts versetzungsfrei aneinandergrenzen, wird durch die folgende Betrachtung gefunden. Die Höhe des Quantenpunkts in Axialrichtung des Nanodrahts, für die eine versetzungsfreie Verbindung der AlₓGa₁₋ₓN- und InN-basierten Abschnitte möglich ist, ist von der Dicke des Nanodrahts abhängig, wie in Figur 5 dargestellt ist. Es zeigt sich, dass der Kurvenverlauf für Durchmesser unterhalb von 12 nm divergiert. Dies bedeutet, dass für geringere Dickenwerte, insbesondere unterhalb von 10 nm, AlₓGa₁₋ₓN- und InN-basierte Abschnitte frei wählbarer Länge miteinander kombiniert werden können. Die AlₓGa₁₋ₓN-basierten Nanodrahtabschnitte und die InN-basierten Quantenpunkte grenzen in dieser Situation versetzungsfrei aneinander. Ein ähnliches Ergebnis wurde in [10] beschrieben, wobei jedoch für das Materialsystem (In,Ga)As/GaAs ein geringerer kritischer Durchmesser gefunden wurde.

Das kleine Diagramm in Figur 5 zeigt die Abhängigkeit der vertikalen Spannungskomponente in z-Richtung im Zentrum des InN-basierten Quantenpunkts von dem Quotienten aus seiner Höhe in Axialrichtung und seiner Dicke. Diese Abhängigkeit wurde durch Finite-Elemente-Simulationen ermittelt. Bei gleichbleibender Höhe und sich verringernder Dicke des InN-basierten Quantenpunkts ergibt sich ein Verlauf der vertikalen Spannungskomponente mit einem anfänglichen Abfall, einem negativen Wert bei gleicher Höhe und Dicke und einer Annäherung an Null für Dicken, die geringer als die Höhe sind. Da die Spannungskomponente direkt das piezoelektrische Feld und die Wellenfunktionen von Elektronen und Löchern im Quantenpunkt beeinflusst, können der Überlapp der Wellenfunktionen und die Strahlungslebensdauer angeregter Zustände des Quantenpunkts durch die Einstellung der Höhe und/oder der Dicke des Quantenpunkts beeinflusst werden. Des Weiteren ergibt die Simulation einen starken Überlapp der Wellenfunktionen, so dass sich eine kurze Strahlungslebensdauer mit entsprechenden Vorteilen für einen Betrieb von Einzelphotonenemittern bei hohen Datenraten ergibt.

Das Bild in Figur 5 zeigt einen Ausschnitt eines Nanodrahts 10 mit einem InN-Quantenpunkt 11 zwischen zwei GaN-Nanodrahtabschnitten 12 mit einer maximalen Dicke des Nanodrahts von rund 8 nm und einer Höhe des Quantenpunkts 11 von rund 2 nm. Die freien Seitenwände des Nanodrahts ermöglichen einen Abbau der mechanischen Spannungen aufgrund der verschiedenen Gitterkonstanten von GaN und InN (siehe auch [11]).

Die beschriebene elastische Spannungsrelaxation in Nanodrähten wurde für Materialsysteme mit einer Gitter-Fehlanpassung unterhalb von 4 % bereits experimentell bestätigt [12]. Für größere Anpassungen hingegen wurden uneinheitliche Ergebnisse berichtet [13]. Für die Kombination von GaN und InN wurden in [14] Nanodrähte mit einer Dicke von 30 nm untersucht. Eine versetzungsfreie Verbindung der Kristalle mit einer Dicke geringer als 10 nm wurde jedoch bisher nicht beschrieben.

Figur 6 illustriert die Übergangsenergie zwischen Elektronen- und Lochzuständen im Quantenpunkt in Abhängigkeit von dessen Höhe h in Axialrichtung des Nanodrahts für verschiedene Dicken des Nanodrahts. Diese wurden durch 8-Band-(k·p)-Berechnungen ermittelt. Als besonderer Vorteil der Erfindung zeigt sich, dass die Übergangsenergie und damit die Emissionswellenlänge über einen relativ großen Bereich, insbesondere vom nahen UV-Bereich bis zum mittleren IR-Bereich durch die Einstellung der Dicke des Nanodrahts und/oder der Höhe des Quantenpunkts ohne eine Änderung der Zusammensetzung gewählt werden kann. Der Bereich der Emissionsenergien deckt insbesondere die drei Transmissionsfenster der optischen Datenübertragung bei Höhen des Quantenpunkts zwischen 3 und 6 Monolagen bzw. 0,85 nm bis 1,7 nm ab.

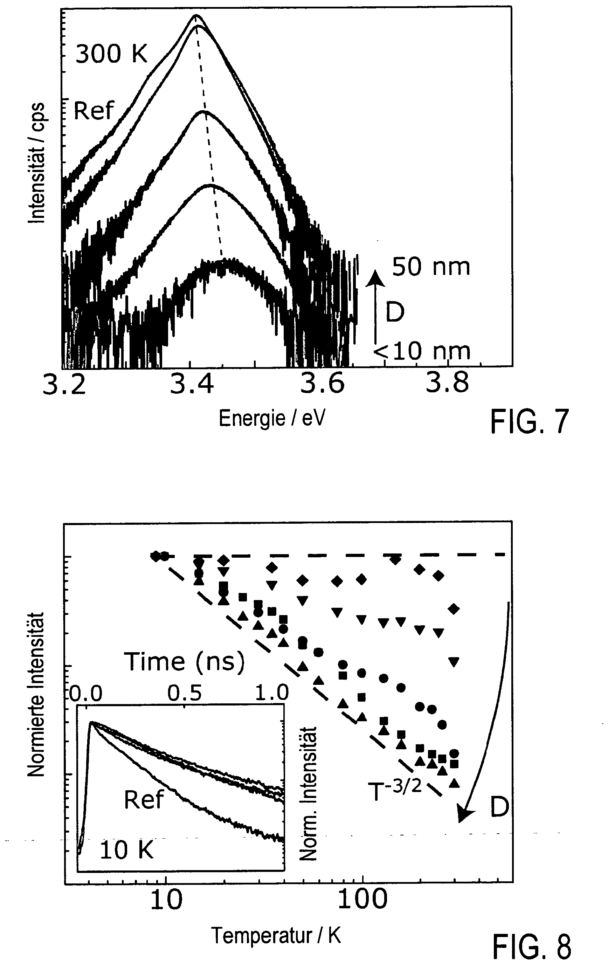

Figur 7 zeigt Photolumineszenz-Spektren, die mit GaN-Nanodrähten verschiedener Dicken bei Raumtemperatur aufgenommen wurden. Im Vergleich zur Referenz-Kurve mit einer Dicke von 50 nm (Kurve Ref) ergibt sich mit verringernder Dicke eine Verschiebung des Emissionsbandes von 3,412 eV bis 3,454 eV für eine Dicke geringer als 10 nm. Diese Verschiebung repräsentiert eine schrittweise Änderung von 3- zu 1-dimensionalen Zustandsdichten freier Exzitonen im Nanodraht mit abnehmender Dicke. Gleichzeitig verringert sich die Intensität der Emission als Ergebnis der Verringerung des emittierenden Gesamtvolumens.

Figur 8 zeigt die Abhängigkeit der spektral integrierten Intensität der Lichtemission von der Temperatur und der Nanodraht-Dicke. Bei geringeren Dicken nimmt die Intensität der Photolumineszenz zu, da Rekombinationsprozesse durch nichtstrahlende Übergänge einen abnehmenden Einfluss haben. Dieses Ergebnis wird durch den Einschub in Figur 8 bestätigt. Die abgedünnten Nanodrähte haben eine größere Lumineszenz-Lebensdauer (300 ps) als die dicken Nanodrähte (140 ps). Vorteilhafterweise ergibt sich im Ergebnis der thermischen Dekomposition der Nanodrähte eine erhöhte Lumineszenz-Quantenausbeute.

Figur 9A zeigt Photolumineszenz-Spektren von (In,Ga)N/GaN-Nanodrähten, die bei verschiedenen Anregungsdichten und einer Temperatur von 10 K aufgenommen wurden. Diese Ergebnisse bestätigen, dass der InN-basierte Abschnitt (siehe Figur 9B) als elektronischer Quantenpunkt 11 auf dem freien Ende des abgedünnten GaN-Nanodrahts wirkt.

Die in der vorstehenden Beschreibung, den Zeichnungen und den Ansprüchen offenbarten Merkmale der Erfindung können sowohl einzeln als auch in Kombination oder Unterkombination für die Verwirklichung der Erfindung in ihren verschiedenen Ausgestaltungen von Bedeutung sein.

## Patentansprüche

1. Lichtemittierende Halbleitereinrichtung (100), umfassend mindestens einen Nanodraht (10), der mindestens einen AlₓGa₁₋ₓN
- basierten Nanodrahtabschnitt (12) mit 0 ≤ x ≤ 1, aufweist und sich entlang einer Axialrichtung (z) erstreckt, wobei
- der Nanodraht (10) mindestens einen InN-basierten Quantenpunkt (11) mit einen InN-Anteil oberhalb von 70 vol%, mit einem dreidimensionalen, atomähnlichen Quanten-Confinement und mit diskreten Energieniveaus aufweist, der entlang der Axialrichtung (z) mindestens einseitig von dem mindestens einen Nanodrahtabschnitt (12) des Nanodrahts (10) begrenzt ist, wobei
- der Nanodraht (10) eine Dicke kleiner oder gleich einer kritischen Dicke aufweist, bei welcher der mindestens eine Quantenpunkt (11) und der benachbarte Nanodrahtabschnitt (12) versetzungsfrei aneinander angrenzen, wobei die Dicke des Nanodrahts (10) kleiner als 10 nm ist, und wobei
- der mindestens eine Quantenpunkt (11) aus InN mit einem derart geringen Ga- und/oder Al-Anteil gebildet ist, dass eine Energiedifferenz zwischen dem niedrigsten gebundenen Energieniveau von Elektronen im Quantenpunkt (11) und dem ersten angeregten Energieniveau der Elektronen größer als thermische Energiefluktuationen von Ladungsträgern im Quantenpunkt (11) bei Raumtemperatur sind,
- die Höhe des mindestens einen Quantenpunkts in der Axialrichtung im Bereich von 0.3 nm bis 3 nm gewählt ist, und
- der Ga- und/oder Al-Anteil im mindestens einen Quantenpunkt (11) geringer als 10 vol-% ist.

2. Halbleitereinrichtung gemäß Anspruch 1, bei der
- die Dicke des Nanodrahts (10) kleiner als 8 nm ist.

3. Halbleitereinrichtung gemäß einem der vorhergehenden Ansprüche, bei der
- mindestens zwei Nanodrahtabschnitte (12) vorgesehen sind, und
- der mindestens eine Quantenpunkt entlang der Axialrichtung (z) beidseitig von den Nanodrahtabschnitten (12) begrenzt ist.

4. Halbleitereinrichtung gemäß einem der vorhergehenden Ansprüche, bei der
- der mindestens eine Quantenpunkt (11) in Radialrichtung mit einer AlₓGa₁₋ₓN-basierte Schicht (13) mit 0 < x < 1 bedeckt ist.

5. Halbleitereinrichtung gemäß einem der vorhergehenden Ansprüche, bei der
- der mindestens eine Quantenpunkt (11) entlang der Axialrichtung (z) eine Höhe derart aufweist, dass eine exzitonische Übergangsenergie zwischen dem niedrigsten Energieniveau eines Elektrons und dem höchsten Energieniveau eines Lochs in dem mindestens einen Quantenpunkt (11) gleich einer Energie von Photonen in einem Wellenlängenbereich von 400 nm bis 3 µm ist.

6. Halbleitereinrichtung gemäß einem der vorhergehenden Ansprüche, bei der
- der Nanodraht (10) eine Vielzahl von Quantenpunkten (11) aufweist, und
- die Halbleitereinrichtung so konfiguriert ist, dass in Reaktion auf eine Anregung von Elektron-Loch-Paaren in den Quantenpunkten (11) eine Vielzahl von Photonen emittiert werden.

7. Halbleitereinrichtung gemäß einem der Ansprüche 1 bis 5, bei der
- der Nanodraht (10) einen einzigen Quantenpunkt (11) aufweist, und
- die Halbleitereinrichtung mit einer elektrischen oder optischen Anregungseinrichtung (30) gekoppelt und so konfiguriert ist, dass in Reaktion auf eine Anregung von Elektron-Loch-Paaren in dem Quantenpunkt (11) mittels der Anregungseinrichtung (30) ein einziges Photon emittiert wird.

8. Halbleitereinrichtung gemäß Anspruch 7, bei der
- der Quantenpunkt (11) entlang der Axialrichtung (z) eine derartige Höhe aufweist, dass eine exzitonische Übergangsenergie zwischen einem niedrigsten Energieniveau eines Elektrons und einem höchsten Energieniveau eines Lochs im Quantenpunkt (11) gleich einer Energie von Photonen bei einer Wellenlänge von 1,3 µm oder 1,55 µm ist.

9. Halbleitereinrichtung gemäß einem der vorhergehenden Ansprüche, mit mindestens einem der Merkmale
- der Nanodraht (10) ist auf einem Substrat (20) angeordnet und die Axialrichtung (z) erstreckt sich entlang der Oberfläche des Substrats (20),
- der Nanodraht (10) ist auf einem Substrat (20) angeordnet und die Axialrichtung (z) erstreckt sich in einer von der Oberfläche des Substrats (20) abweichenden Richtung, insbesondere senkrecht zum Substrat (20),
- der Nanodraht (10) ist mit Elektroden verbunden, die zur elektrischen Anregung der Ladungsträger in dem mindestens einen Quantenpunkt (11) angeordnet sind, und
- der Nanodraht (10) ist mit einem optischen Element ausgestattet, das für eine Einkopplung von Photonen aus dem mindestens einen Quantenpunkt (11) in einen Lichtwellenleiter angeordnet ist.

10. Verfahren zur Herstellung einer lichtemittierenden Halbleitereinrichtung (100) gemäß einem der vorhergehenden Ansprüche, mit den Schritten:
- Bildung von dem mindestens einen drahtförmigen Nanodrahtabschnitt (12), basierend auf AlₓGa₁₋ₓN mit 0 ≤ x ≤ 1, und
- Bildung des mindestens einen InN-basierten Quantenpunkts mit einen InN-Anteil oberhalb von 70 vol%, mit Höhe in der Axialrichtung im Bereich von 0.3 nm bis 3 nm und mit Ga- und/oder Al-Anteil geringer als 10 vol-%, an einem freien Ende des Nanodrahtabschnitts (12), wobei
- eine thermische Dekomposition des AlₓGa₁₋ₓN derart vorgesehen ist, dass die Dicke des Nanodrahtabschnitts (12) kleiner als 10 nm ist, und
- das Erreichen der Dicke durch eine Beobachtung des mindestens einen Nanodrahts (10) während der Dekomposition festgestellt wird.

11. Verfahren gemäß Anspruch 10, bei dem die Bildung des Nanodrahtabschnitts (12) und des Quantenpunkts (11) umfasst:
- ein Wachstum des Nanodrahtabschnitts (12) und ein nachfolgendes epitaktisches Wachstum des Quantenpunkts (11) auf dem Nanodrahtabschnitt (12), oder
- eine Abscheidung einer AlₓGa₁₋ₓN-basierten Schicht auf einem Substrat (20) und einer InN-basierten Schicht auf der AlₓGa₁₋ₓN-basierten Schicht mit einem nachfolgenden selektiven Ätzen der Schichten derart, dass der Nanodrahtabschnitt (12) mit dem Quantenpunkt (11) gebildet wird.

12. Verfahren gemäß einem der Ansprüche 10 bis 11, bei dem
- auf dem Quantenpunkt (11) abwechselnd mindestens ein weiterer Nanodrahtabschnitt (12) und mindestens ein weiterer Quantenpunkt (11) gebildet werden.

13. Verfahren gemäß einem der Ansprüche 10 bis 12, mit dem Schritt
- Einstellung einer Emissionswellenlänge der Halbleitereinrichtung (100) mittels Einstellung der Höhe des Quantenpunkts (11) entlang der Axialrichtung (z) und/oder der Dicke des Nanodrahts (10).

## Claims

1. Light emitting semiconductor device (100), comprising at least one nanowire (10) having at least one AlₓGa₁₋ₓN-based nanowire section (12) with 0 ≤ x ≤ 1, and extending along an axial direction (z), wherein
- the nanowire (10) has at least one InN-based quantum dot (11) with an In content above 70 %, with a three-dimensional, atom-like quantum confinement and with discrete energy levels, which is bounded along the axial direction (z) at least on one side by the at least one nanowire section (12) of the nanowire (10), wherein
- the nanowire (10) has a thickness less than or equal to a critical thickness at which the at least one quantum dot (11) and the adjacent nanowire section (12) adjoin each other without dislocation, wherein the thickness of the nanowire (10) is less than 10 nm, and wherein
- the at least one quantum dot (11) is formed of InN with such a low Ga and/or Al content that an energy difference between the lowest bound energy level of electrons in the quantum dot (11) and the first excited energy level of the electrons is greater than thermal energy fluctuations of charge carriers in the quantum dot (11) at room temperature,
- the height of the at least one quantum dot in the axial direction is selected in the range from 0,3 nm to 3 nm, and
- the Ga and/or Al content in the at least one quantum dot (11) is less than 10 vol%.

2. Semiconductor device according to claim 1, wherein
- the thickness of the nanowire (10) is less than 8 nm.

3. Semiconductor device according to one of the foregoing claims, wherein
- at least two nanowire sections (12) are provided, and
- the at least one quantum dot is bounded on both sides along the axial direction (z) by the nanowire sections (12).

4. Semiconductor device according to one of the foregoing claims, wherein
- the at least one quantum dot (11) is covered in a radial direction with an AlₓGa₁₋ₓN-based layer (13) with 0 ≤ x ≤ 1.

5. Semiconductor device according to one of the foregoing claims, wherein
- the at least one quantum dot (11) has a height along the axial direction (z) such that an excitonic transition energy between the lowest energy level of an electron and the highest energy level of a hole in the at least one quantum dot (11) is equal to an energy of photons in a wavelength range from 400 nm to 3 µm.

6. Semiconductor device according to one of the foregoing claims, wherein
- the nanowire (10) has a plurality of quantum dots (11), and
- the semiconductor device is configured to emit a plurality of photons in response to an excitation of electron-hole pairs in the quantum dots (11).

7. Semiconductor device according to one of claims 1 to 5, wherein
- the nanowire (10) has one single quantum dot (11), and
- the semiconductor device is coupled to an electrical or optical excitation device (30) and configured such that one single photon is emitted in response to an excitation of electron-hole pairs in the quantum dot (11) by said excitation device (30).

8. Semiconductor device according to claim 7, wherein
- the quantum dot (11) has such a height along the axial direction (z) that an excitonic transition energy between a lowest energy level of an electron and a highest energy level of a hole in the quantum dot (11) is equal to an energy of photons at a wavelength of 1,3 µm or 1,55 µm.

9. Semiconductor device according to one of the foregoing claims, having at least one of the features
- the nanowire (10) is arranged on a substrate (20) and the axial direction (z) extends along the surface of the substrate (20),
- the nanowire (10) is arranged on a substrate (20) and the axial direction (z) extends in a direction deviating from the surface of the substrate (20), in particular perpendicular to the substrate (20),
- the nanowire (10) is connected to electrodes which are arranged for an electrical excitation of the charge carriers in the at least one quantum dot (11), and
- the nanowire (10) is provided with an optical element arranged for coupling photons from the at least one quantum dot (11) into an optical waveguide.

10. Method of manufacturing a light-emitting semiconductor device (100) according to one of the foregoing claims, comprising the steps of
- formation of the at least one wire-shaped nanowire section (12) based on AlₓGa₁₋ₓN with 0 ≤ x ≤ 1, and
- formation of the at least one InN-based quantum dot (11) with an In content above 70 %, with a height in the axial direction in the range from 0,3 nm to 3 nm and with the Ga and/or Al content less than 10 vol% at a free end of the nanowire section (12), wherein
- a thermal decomposition of the AlₓGa₁₋ₓN is provided such that the thickness of the nanowire section (12) is less than 10 nm, and
- the achievement of the thickness is determined by monitoring the at least one nanowire (10) during the decomposition.

11. Method according to claim 10, wherein the formation of the nanowire section (12) and the quantum dot (11) comprises:
- a growth of the nanowire section(12) and a subsequent epitaxial growth of the quantum dot (11) on the nanowire section(12), or
- a deposition of an AlₓGa₁₋ₓN-based layer on a substrate (20) and an InN-based layer on the AlₓGa₁₋ₓN-based layer with subsequent selective etching of the layers such that the nanowire section (12) with the quantum dot (11) is formed.

12. Method according to one of the claims 10 to 11, wherein
- on the quantum dot (11) alternately at least one further nanowire section (12) and at least one further quantum dot (11) are formed.

13. Method according to one of the claims 10 to 12, comprising the step
- setting an emission wavelength of the semiconductor device (100) by adjusting the height of the quantum dot (11) along the axial direction (z) and/or the thickness of the nanowire (10).

## Revendications

1. Dispositif semi-conducteur (100) émetteur de lumière, comprenant au moins un nanofil (10), qui présente au moins un tronçon de nanofil (12) à base de AlₓGa₁₋ₓN avec 0 ≤ x ≤ 1 et s'étend le long d'une direction axiale (z)
dans lequel
- le nanofil (10) présente au moins un point quantique (11) à base d'InN avec une fraction d'InN supérieure à 70 % en vol. avec un confinement quantique tridimensionnel similaire à un atome et avec des niveaux d'énergie discrets, qui est délimité le long de la direction axiale (z) au moins d'un côté par l'au moins un tronçon de nanofil (12) du nanofil (10),
dans lequel
- le nanofil (10) présente une épaisseur inférieure ou égale à une épaisseur critique, pour laquelle l'au moins un point quantique (11) et le tronçon de nanofil (12) adjacent se jouxtent l'un l'autre sans décalage, dans lequel l'épaisseur du nanofil (10) est inférieure à 10 nm et dans lequel
- l'au moins un point quantique (11) est formé à partir d'InN avec une fraction en Ga et/ou en Al si faible qu'une différence d'énergie entre le niveau d'énergie lié le plus bas d'électrons dans le point quantique (11) et le premier niveau d'énergie excité des élections est supérieure aux fluctuations d'énergie thermique de porteurs de charge dans le point quantique (11) à température ambiante,
- la hauteur de l'au moins un point quantique dans la direction axiale est choisie dans la plage de 0,3 nm à 3 nm, et
- la teneur en Ga et/ou en Al dans au moins un point quantique (11) est inférieure à 10 % en vol.

2. Dispositif semi-conducteur selon la revendication 1, où
- l'épaisseur du nanofil (10) est inférieure à 8 nm.

3. Dispositif semi-conducteur selon l'une quelconque des revendications précédentes, où
- au moins deux tronçons de nanofil (12) sont prévus, et
- l'au moins un point quantique est délimité le long de la direction axiale (z) de part et d'autre des tronçons de nanofil (12).

4. Dispositif semi-conducteur selon l'une quelconque des revendications précédentes, où
- l'au moins un point quantique (11) est recouvert dans la direction radiale d'une couche à base de AlₓGa₁₋ₓN (13) avec 0 ≤ x ≤ 1.

5. Dispositif semi-conducteur selon l'une quelconque des revendications précédentes, où
- l'au moins un point quantique (11) présente le long de la direction axiale (z) une hauteur telle qu'une énergie de transition excitonique entre le niveau d'énergie le plus bas d'un électron et le niveau d'énergie le plus haut d'un trou dans l'au moins un point quantique (11) est égale à une énergie de photons dans une plage de longueurs d'onde de 400 nm à 3 µm.

6. Dispositif semi-conducteur selon l'une quelconque des revendications précédentes, où
- le nanofil (10) présente une pluralité de points quantiques (11), et
- le dispositif semiconducteur est configuré de telle sorte qu'en réaction à une excitation de paires électron-trou dans les points quantiques (11), une pluralité de photons soient émis.

7. Dispositif semi-conducteur selon l'une quelconque des revendications 1 à 5, où
- le nanofil (10) présente un unique point quantique (11), et
- le dispositif semiconducteur est couplé à un dispositif d'excitation (30) électrique ou optique et est configuré de telle sorte qu'en réaction à une excitation de paires électron-trou dans le point quantique (11) au moyen du dispositif d'excitation (30), un photon unique soit émis.

8. Dispositif semi-conducteur selon la revendication 7, où
- le point quantique (11) présente le long de la direction axiale (z) une hauteur telle qu'une énergie de transition excitonique entre un niveau d'énergie le plus bas d'un électron et un niveau d'énergie le plus haut d'un trou dans le point quantique (11) est égale à une énergie de photons pour une longueur d'onde de l'ordre de 1,3 µm ou 1,55 µm.

9. Dispositif semi-conducteur selon l'une quelconque des revendications précédentes, avec au moins une des caractéristiques
- le nanofil (10) est disposé sur un substrat (20) et la direction axiale (z) s'étend le long de la surface du substrat (20),
- le nanofil (10) est disposé sur un substrat (20) et la direction axiale (z) s'étend dans une direction divergeant de la surface du substrat (20), en particulier de manière perpendiculaire par rapport au substrat (20),
- le nanofil (10) est relié à des électrodes, qui sont disposées aux fins de l'excitation électrique des porteurs de charge dans l'au moins un point quantique (11), et
- le nanofil (10) est équipé d'un élément optique, qui est disposé dans une fibre optique pour une injection de photons provenant de l'au moins un point quantique (11).

10. Procédé de fabrication d'un dispositif semi-conducteur (100) émetteur de lumière selon l'une quelconque des revendications précédentes, avec les étapes :
- de formation de l'au moins un tronçon de nanofil (12) en forme de fil métallique à base de AlₓGa₁₋ₓN avec 0 ≤ x ≤ 1, et
- de formation de l'au moins un point quantique à base d'InN avec une fraction d'InN supérieure à 70 % en vol. avec une hauteur dans la direction axiale dans la plage de 0,3 nm à 3 nm et avec une fraction de Ga et/ou d'Al inférieure à 10 % en vol. sur une extrémité libre du tronçon de nanofil (12), dans lequel
- une décomposition thermique du AlₓGa₁₋ₓN est prévue de telle manière que l'épaisseur du tronçon de nanofil (12) est inférieure à 10 nm, et
- l'atteinte de l'épaisseur est constatée par une observation de l'au moins un nanofil (10) au cours de la décomposition.

11. Procédé selon la revendication 10, où la formation du tronçon de nanofil (12) et du point quantique (11) comprend :
- une croissance du tronçon de nanofil (12) et une croissance épitactique qui suit du point quantique (11) sur le tronçon de nanofil (12), ou
- un dépôt d'une couche à base de AlₓGa₁₋ₓN sur un substrat (20) et d'une couche à base d'InN sur la couche à base de AlₓGa₁₋ₓN avec une gravure sélective qui suit des couches de telle manière que le tronçon de nanofil (12) est formé avec le point quantique (11).

12. Procédé selon l'une quelconque des revendications 10 à 11, où
- au moins un autre tronçon de nanofil (12) et au moins un autre point quantique (11) sont formés en alternance sur le point quantique (11).

13. Procédé selon l'une quelconque des revendications 10 à 12, avec l'étape
- de réglage d'une longueur d'onde d'émission du dispositif semi-conducteur (100) au moyen du réglage de la hauteur du point quantique (11) le long de la direction axiale (z) et/ou de l'épaisseur du nanofil (10) .
